**Europäisches Patentamt**

**European Patent Office**

**Office européen des brevets**

(19)

(11) Veröffentlichungsnummer: **0 071 916**
**B1**

(12) **EUROPÄISCHE PATENTSCHRIFT**

(45) Veröffentlichungstag der Patentschrift:
**15.10.86**

(21) Anmeldenummer: **82106923.4**

(22) Anmeldetag: **30.07.82**

(51) Int. Cl.⁴: **H 01 L 29/167,** H 01 L 29/08,
H 01 L 29/78

(54) **Leistungs-MOS-Feldeffekttransistor und Verfahren zu seiner Herstellung.**

(30) Priorität: **12.08.81 DE 3131914**

(43) Veröffentlichungstag der Anmeldung:
**16.02.83 Patentblatt 83/7**

(45) Bekanntmachung des Hinweises auf die Patenterteilung:
**15.10.86 Patentblatt 86/42**

(84) Benannte Vertragsstaaten:
**CH DE FR GB IT LI**

(56) Entgegenhaltungen:
**DE-A-3 037 316**
**US-A-3 440 113**

**ELECTRONIC DESIGN, Band 28, Nr. 20, September
1980, Seiten 31-32, Rochelle Park, USA "TMOS
Bolsters power MOSFETs"**
**TECHNICAL DIGEST OF THE INTERNATIONAL
ELECTRON DEVICES MEETING, Washington, 4.-6.
Dezember 1978, Seiten 657-660, IEEE, New York;
USA D. FUOSS et al.: "A fully implanted V-groove
power MOSFET"**

(73) Patentinhaber: **Siemens Aktiengesellschaft Berlin
und München, Wittelsbacherplatz 2, D-8000
München 2 (DE)**

(72) Erfinder: **Schuh, Gottfried, Lutzstrasse 16, D-8900
Augsburg (DE)**
Erfinder: **Tihanyi, Jenö, Dr.- Ing.,
Wolfratshauserstrasse 179 b, D-8000 München 71
(DE)**

## Beschreibung

Die vorliegende Anmeldung bezieht sich auf einen Leistungs - MOS - Feldeffekttransistor (MOS-FET) mit einem Halbleiterkörper, enthaltend eine erste Zone vom ersten Leitungstyp, eine na die erste Oberfläche des Halbleiterkörpers tretende Kanalzone vom zweiten Leitungstyp, ein ein der Kanalzone angeordnete, an der ersten Oberfläche liegende Sourcezone vom ersten Leitungstyp, wobei die erste Zone die Drainzone bildet und an die erste Oberfläche des Halbleiterkörpers tritt, mit einem die Kanalzone und die Sourcezone verbindenden Sourcekontakt, mit einem an der der ersten Oberfläche des Halbleiterkörpers gegenüberliegenden zweiten Oberflächen angebrachten Drainkontakt, sowie mit einer gegen die erste Oberfläche isolierten Gateelektrode.

Leistungs-MOS-FET dieser Art sind Gegenstand vieler Veröffentlichungen (vergleiche z.B. "Electronic Design", September 1, 1980, Seite 31, 32). Sie eignen sich zum Schalten von Lasten aller Art bei sehr geringer Steuerleistung. Ein mögliches Anwendungsgebiet ist der Einsatz in Gleichstrom-Choppern und Motorsteuerungen. Die Last hat in diesen Anwendungsfällen einen hohen induktiven Anteil. Beim Abschalten der induktiven Last fließen im Schaltkreis Ausgleichsströme. Bei Verwendung von bipolaren Halbleiterbauelementen hat man daher Freilaufdioden vorgesehen, die den Halbleiterbauelementen antiparallel geschaltet sind. Die Ausgleichsströme fließen dann durch diese Freilaufdioden.

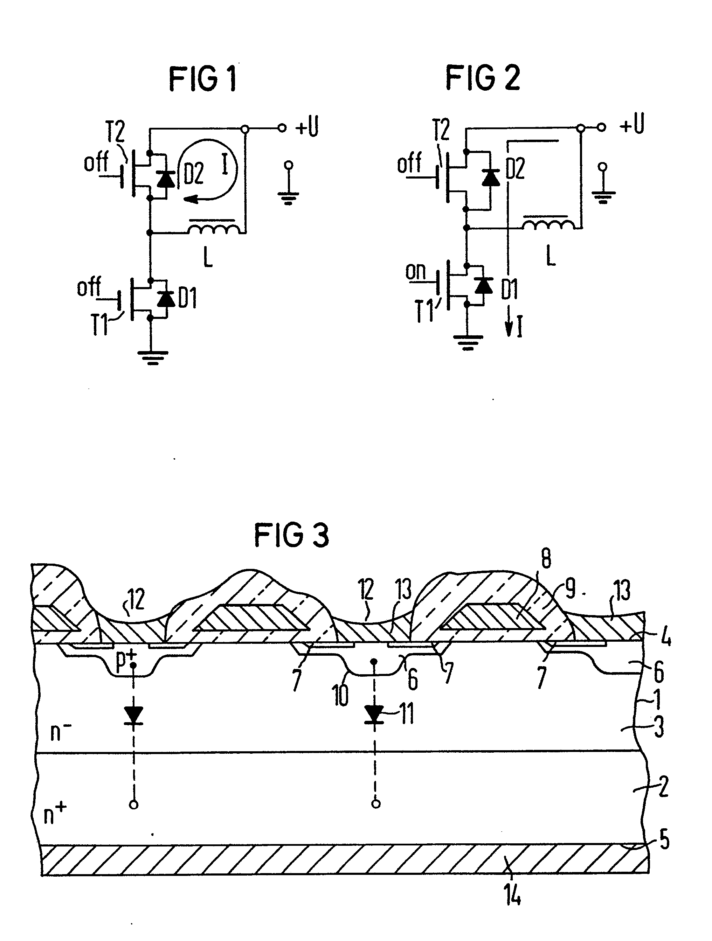

Bei der Verwendung von Leistungs-MOS-FET in den genannten Schaltungen kann man aber unter bestimmten Voraussetzungen auf solche Freilaufdioden verzichten, da diese eine sogenannte integrierte Inversdiode aufweisen, die durch die Drainzone und dem durch den Sourcekontakt kontaktierten Teil der Kanalzone gebildet sind. Die integrierte Inversdiode hat einen bipolaren Leitungsmechanismus und kann damit eine gewisse Ladung speichern. Ein Beispiel für eine Schaltung, bei der die integrierten Inversdioden ausgenutzt werden, ist in den Fig. 1 und 2 gezeigt. Zunächst wird von dem Zustand ausgegangen, bei dem beide Transistoren $T_1$ und $T_2$ ausgeschaltet sind (Fig. 1). Dann fließt ein Ausgleichsstrom I durch die Inversdiode D2. Wenn beim Einschalten des Transistors $T_1$ der Ausgleichsstrom der induktiven Last L von der Inversdiode D2 des MOS-FET $T_2$ auf den Transistorteil des MOS-FET $T_1$ umkommutiert wird, fließt ein Rückstrom durch die Inversdiode D2 bei noch großer Spannung am Transistor $T_1$ (Fig. 2). Dies führt zu hohen Verlusten im MOS-FET $T_1$. Es wurde daher angeregt, dem MOS-FET $T_1$ in diesen Fällen eine externe schnelle Diode antiparallel zu schalten (vergleiche Proceedings of Powercon 7 "Using the Power MOSFET's Integral Reverse Rectifier", Seite J2—9). Das bedeutet jedoch einen erheblichen zusätzlichen Aufwand.

Der Erfindung liegt die Aufgabe zugrunde, das Rückstromverhalten der integrierten Inversdiode so zu verbessern, daß die Verlustleistung im MOS-FET auch ohne externe Diode verringert und/oder die Betriebsfrequenz der Schaltung erhöht werden kann.

Die Erfindung ist dadurch gekennzeichnet, daß mindestens die Drainzone mit Rekombinationszentren bildenden Metallatomen dotiert ist.

In der DE—AS 26 32 448 ist ein CMOS-Bauelement beschrieben worden, das Gold als Rekombinationszentren enthält. Das Gold hat hier den Zweck, die Stromverstärkung eines parasitären, d.h. unerwünschten Thyristors herabzusetzen und dadurch eine mögliche bipolare Funktion zu unterbinden und zu eliminieren. Im Gegensatz dazu handelt es sich bei der obengenannten Inversdiode nicht um ein parasitäres und unerwünschtes Bauelement, sondern um ein Bauelement, dessen Eigenschaft verbessert und optimiert werden soll.

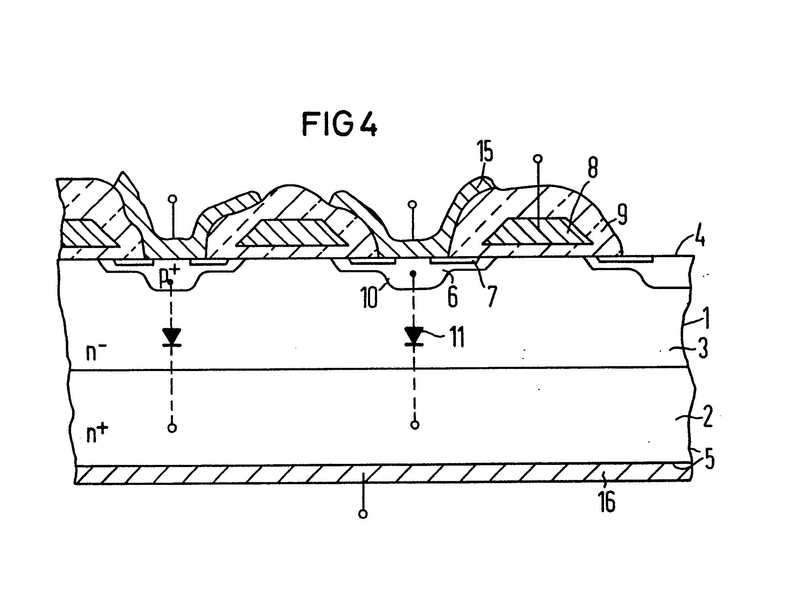

Die Erfindung wird an Hand eines Ausführungsbeispiels in Verbindung mit den Fig. 3 und 4 näher erläutert. Es zeigen:

Fig. 3 den Halbleiterkörper eines Leistungs-MOS-FET entsprechend einem wesentlichen Verfahrensschritt der Erfindung und

Fig. 4 den mit Kontakten versehenen Halbleiterkörper eines Leistungs-MOS-FET.

Der Halbleiterkörper nach Fig. 3 ist mit 1 bezeichnet. Er besteht aus einem stark n-dotierten Substrat 2 mit einer Dotierung von $10^{17}$ bis $10^{19}$ Atomen $cm^{-3}$. Auf dem Substrat 2 ist eine epitaktische, schwach n-dotierte Schicht 3 aufgebracht. Ihre Dotierung und Dicke hängt von der Spannungsfestigkeit des Bauelements ab. Ein 500 V-MOSFET z.B. hat eine etwa 45 µm dicke Schicht mit einer Dotierung von $2{,}7 \cdot 10^{14} \ cm^{-3}$. Der Halbleiterkörper 1 hat eine obere Oberfläche 4 und eine untere Oberfläche 5. An der oberen Oberfläche 4 ist eine stark p-dotierte Zone 6 implantiert oder eindiffundiert, die an die Oberfläche 4 des Halbleiterkörpers tritt. Diese Zone ist die Kanalzone des MOS-FET. In die Zone 6 ist eine Sourcezone 7 eingebettet, die stark n-dotiert ist. Die Sourcezone wird von einem nicht dargestellten Sourcekontakt kontaktiert, der auch die Kanalzone 6 kontaktiert. Auf der Oberfläche 4 ist eine Isolierschicht 9 angeordnet, die beispielsweise aus Siliciumdioxid besteht. Weiterhin ist über der Oberfläche 4 eine Gateelektrode 8, z.B. aus Polysilicium, aufgebracht, die gegen die Oberfläche durch die Isolierschicht 9 isoliert ist. Oberhalb der Sourcezone 7 und der Kanalzone 6 ist ein Kontaktloch 12 frei gelassen, in dem später der Sourcekontakt angebracht wird.

In den Halbleiterkörper ist eine Diode 11 eingezeichnet, die die oben erwähnte integrierte Inversdiode darstellt. Diese Inversdiode wird durch die Kanalzone 6 und die Drainzone 3 gebildet. Der zwischen den Zonen 6 und 3 liegende pn-Übergang 10 ist zugleich der pn-Übergang dieser Diode 11. Im normalen Betriebszustand des MOS-FET, d.h. bei einem Ladungsträgerfluß von Sourcezone 7 zur Drainzone 3, spielt diese Diode keine Rolle, da sie in Sperrichtung geschaltet ist. Sie entfaltet ihre Wirkung erst dann, wenn sich der Strom und die Spannung durch den MOS-FET durch die oben beschriebenen Einwirkung einer induktiven Last umkehrt und als Ausgleichsstrom nun durch die Diode 11 fließen kann. In diesem Fall fließt der Strom also von der Kanalzone 6 in die Drainzone 3. Dabei wird die Drainzone und insbesondere die Epitaxieschicht 3 von Ladungsträgern beider Polaritäten überschwemmt und eine hohe gespeicherte Ladung kommt zu stande. Kommt es dann infolge Ab- oder Umschalten einer induktiven Last zu einem Rückstrom, durch die Diode, führt dies in Verbindung mit der zuerst hohen Transistorspannung am einschaltenden Transistor zu den erwähnten hohen Schaltverlusten.

Zur Verminderung dieser Verluste wird der Halbleiterkörper vor dem Anbringen der Kontaktelektroden einseitig, d.h. entweder in den Kontaktfenstern 12 oder auf der Oberfläche 5 oder auf beiden Seiten mit einem Rekombinationszentren bildenden Metall, z.B. Gold, belegt. Die Goldschicht ist mit 13, 14 bezeichnet. Das Gold kann z.B. durch Eintauchen in ein Goldbad oder auch durch Sputtern, d.h. durch Katodenzerstäubung, aufgebracht werden. Die aufgebrachte Schicht kann zwischen 0,1 und 20 nm dick sein. Das Gold wird dann bei einer Temperatur in den Halbleiterkörper eindiffundiert, die niedriger ist als diejenige Temperatur, bei der die Zonen 6, 7 und die Oxidschicht 9 hergestellt wurde. Als zweckmäßig hat sich eine Temperatur von 700 bis 800°C erwiesen. Es ist zweckmäßig, soviel Gold in den MOS-FET einzubringen, wie die Dotierung der n Epitaxieschicht 3 mit die Leitfähigkeit bestimmenden Dotierstoffen beträgt. Die Goldkonzentration kann sogar etwas höher als die niedrigste, die Leitfähigkeit bestimmende Dotierung sein. Als Maximum dürfte etwa der Faktor 3 in Frage kommen. Als untere Grenze ist der Faktor 0,2 anzusehen.

Nach dem Eindiffundieren des Goldes werden etwa vorhandene Reste auf den Oberflächen 4, 5 und auf der Isolierschicht 9 mit Königswasser weggeätzt. Anschließend werden auf die Oberflächen 4, 5 Kontakte 15, 16 aufgebracht (Fig. 4). Üblich ist das Aufdampfen einer Aluminiumschicht.

Anstelle von Gold können auch andere Rekombinationszentren bildende Metalle, z.B. Platin, eindiffundiert werden.

Es ist auch möglich, die obere Oberfläche 4 vor dem Aufbringen der Isolierschicht 9 und der Gateelektrode 8 ganzflächig mit dem Rekombinationszentren bildenden Metall zu belegen und diese ganzflächig einzudiffundieren.

Durch die Rekombinationszentren werden die gespeicherte Ladung und dadurch die Schaltverluste im umschaltenden MOS-FET entscheidend herabgesetzt. Damit kann die Frequenz der Schaltung entsprechend erhöht werden. Auf der anderen Seite ist lediglich mit einer unbedeutenden Erhöhung des Durchlaßwiderstandes $R_{on}$ des Transistors zu rechnen. Für den genannten Extremfall der die Dotierung in der Zone 3 um das Dreifache höheren Golddotierung ergibt sich eine Erhöhung des $R_{on}$ um 20%.

**Patentansprüche**

1. Leistungs-MOS-Feldeffekttransistor (MOS-FET) mit einem Halbleiterkörper (1), enthaltend eine erste Zone (3) vom ersten Leitungstyp, eine an die erste Oberfläche (4) des Halbleiterkörpers tretende Kanalzone (6) vom zweiten Leitungstyp, eine in der Kanalzone angeordnete, an der ersten Oberfläche liegende Sourcezone (7) vom ersten Leitungstyp, wobei die erste Zone (3) die Drainzone bildet und an die erste Oberfläche des Halbleiterkörpers tritt, mit einem die Kanalzone und die Sourcezone verbindenden Sourcekontakt (15), mit einem an der der ersten Oberfläche des Halbleiterkörpers gegenüberliegenden zweiten Oberfläche (5) angebrachten Drainkontakt (16), sowie mit einer gegen die erste Oberfläche isolierten Gateelektrode (8), dadurch gekennzeichnet, daß mindestens die Drainzone (3) mit Rekombinationszentren bildenden Metallatomen dotiert ist.

2. Leistungs-MOS-FET nach Anspruch 1, dadurch gekennzeichnet, daß die Dotierungskonzentration der Metallatome zwischen dem 0,2 fachen und dem Dreifachen der die Leitfähigkeit der Drainzone bestimmenden Dotierstoffkonzentration liegt.

3. Leistungs-MOS-FET nach Anspruch 2, dadurch gekennzeichnet, daß die Dotierungskonzentration höhert ist als die Mindestdotierung der Drainzone (3) mit die Leitfähigkeit bestimmenden Dotierstoffen.

4. Leistungs-MOS-FET nach einem der Ansprüche 1 bis 3, dadurch gekennzeichnet, daß die Metallatome Goldatome sind.

5. Verfahren zum Herstellen eines MOS-FET nach einem der Ansprüche 1 bis 4, dadurch gekennzeichnet, daß das Metall vor dem Anbringen der Kontakte und vor dem Anbringen der Gateelektrode auf mindestens eine Oberfläche des Halbleiterkörpers ganzflächig aufgebracht wird und daß das Metall dann bei einer Temperatur eindiffundiert wird, die unterhalb derjenigen Temperatur liegt, bei der die Zonen (6, 7) des Halbleiterkörpers und die Isolierschicht (9) hergestellt werden.

6. Verfahren zum Herstellen eines MOS-FET nach einem der Ansprüche 1 bis 4, dadurch gekennzeichnet, daß das Metall vor dem Anbringen der Kontakte und nach dem Anbringen der Gateelektrode auf mindestens eine Oberfläche (4) selektiv aufgebracht wird und daß das Metall dann bei einer Temperatur eindiffundiert wird, die unterhalb derjenigen Temperatur liegt, bei der die Zonen (6, 7) des Halbleiterkörpers und die Isolierschicht (9) hergestellt werden.

7. Verfahren nach Anspruch 5 oder 6, dadurch gekennzeichnet, daß das Metall auf die Oberfläche des Halbleiterkörpers aufgesputtert wird.

8. Verfahren nach Anspruch 6 oder 7, dadurch gekennzeichnet, daß das Metall in einer Dicke von 0,1 bis 20 nm aufgebracht wird.

9. Verfahren nach einem der Ansprüche 6 bis 8, dadurch gekennzeichnet, daß bei Verwendung von Gold als Rekombinationszentren bildendem Metall eine zwischen 700 und 800°C liegende Diffusionstemperatur eingestellt wird.

**Revendications**

1. Transistor à effet de champ MOS de puissance (MOS-FET) comportant un corps semiconducteur (1) contenant une première zone (3) possédant le premier type de conductivité, une zone de canal (6) possédant le second type de conductivité et s'étendant au niveau de la première surface (4) du corps semiconducteur, une zone de source (7) possédant le premier type de conductivité, disposée dans la zone du canal et située au niveau de la première surface, la première zone (3) constituant la zone de drain et s'étendant au niveau de la première surface du corps semiconducteur, et comportant un contact de source (15) reliant la zone de canal à la zone de source, un contact de drain (16) disposé au niveau de la seconde surface (5) située à l'opposé de la première surface du corps semiconducteur, ainsi qu'une électrode de grille (8) isolée par rapport à la première surface, caractérisé par le fait qu'au moins la zone de drain (3) est dopée par des atomes d'un métal constituant des centres de recombinaison.

2. Transistor MOS-FET de puissance suivant la revendication 1, caractérisé par le fait que la concentration de dopage des atomes de métal est comprise entre 0,2 et trois fois la concentration de substance dopante déterminant la conductivité de la zone de drain.

3. Transistor MOS-FET de puissance suivant la revendication 2, caractérisé par le fait que la concentration de dopage est supérieure au dopage minimal de la zone de drain (3), réalisé avec la substance dopante déterminant la conductivité.

4. Transistor MOS-FET de puissance suivant l'une des revendications 1 à 3, caractérisé par le fait que les atomes de métal sont des atomes d'or.

5. Procédé pour fabriquer un transistor MOS-FET suivant l'une des revendications 1 à 4, caractérisé par le fait qu'avant le dépôt des contacts et avant le dépôt de l'électrode de grille, on dépose le métal sur toute l'étendue d'au moins une surface du corps semiconducteur et qu'on fait pénétrer ensuite le métal par diffusion à une température qui est inférieure à la température pour laquelle les zones (6, 7) du corps semiconducteur et les couches isolantes (9) sont fabriquées.

6. Procédé pour fabriquer un transistor MOS-FET suivant l'une des revendications 1 à 4, caractérisé par le fait qu'avant le dépôt des contacts et après le dépôt de l'électrode de grille, on dépose de façon sélective le métal sur au moins une surface (4) et qu'on fait pénétrer le métal par diffusion à une température qui est inférieure à la température pour laquelle les zones (6, 7) du corps semiconducteur et la couche isolante (9) sont fabriquées.

7. Procédé suivant l'une des revendications 5 ou 6, caractérisé par le fait qu'on dépose par pulvérisation le métal sur la surface du corps semiconducteur.

8. Procédé suivant la revendication 6 ou 7, caractérisé par le fait qu'on dépose le métal sur une épaisseur comprise entre 0,1 et 20 nm.

9. Procédé suivant l'une des revendications 6 à 8, caractérisé par le fait que, dans le cas de l'utilisation de l'or comme métal formant des centres de recombinaison, on règle une température de diffusion comprise entre 700 et 800°C.

**Claims**

1. A power-MOS-field effect transistor (MOS-FET) comprising a semiconductor body (1), containing a first zone (3) of the first conductivity type, a channel zone (6) of the second conductivity type adjoining the first surface (4) of the semiconductor body, a source zone (7) of the first conductivity type arranged in the channel zone and adjoining the first surface, the first zone (3) forming the drain zone and adjoining the first surface of the semiconductor body, a source contact (15) connecting the channel zone and the source zone, a drain contact (16) arranged on the second surface (5) of the semiconductor body which is located opposite the first surface thereof, and a gate electrode (8) which is insulated from the first surface, characterised in that at least the drain zone (3) is doped with metal atoms which form recombination centres.

2. A power-MOS-FET as claimed in Claim 1, characterised in that the doping concentration of the metal atoms is between 0.2 and 3 times the dopant concentration which determines the conductivity of the drain zone.

3. A power-MOS-FET as claimed in Claim 2, characterised in that the doping concentration is higher than the minimum doping of the drain zone (3) with dopants which determine the conductivity.

4. A power-MOS-FET as claimed in one of Claims 1 to 3, characterised in that the metal atoms are gold atoms.

5. A process for the production of a MOS-FET as claimed in one of Claims 1 to 4, characterised in that, prior to the application of the contacts and prior to the application of the gate electrode, the metal is applied to the whole of at least one surface of the semiconductor body; and that the metal is then diffused-in at a temperature below the temperature at which the zones (6, 7) of the semiconductor body and the insulating layer (9) are produced.

6. A process for the production of a MOS-FET as claimed in one of Claims 1 to 4, characterised in that, prior to the application of the contacts and following the application of the gate electrode, the metal is selectively applied to at least one surface (4); and that the metal is then diffused-in at a temperature which is below the temperature at which the zones (6, 7) of the semiconductor body and the insulating layer (9) are produced.

7. A process as claimed in Claim 5 or Claim 6, characterised in that the metal is sputtered on to the surface of the semiconductor body.

8. A process as claimed in Claim 6 or Claim 7, characterised in that the metal is applied in a thickness of 0.1 to 20 nm.

9. A process as claimed in one of Claims 6 to 8, characterised in that, when gold is used as the metal which forms recombination centres, a diffusion temperature of between 700 and 800°C is set.

5

# FIG 1

# FIG 2

# FIG 3

# FIG 4